# EUROPEAN PATENT SPECIFICATION

(11) **EP 2 985 851 B1**
(45) Date of publication and mention of the grant of the patent: **07.03.2018**
(21) Application number: 13878440.0
(22) Date of filing: 19.11.2013
(51) Int. Cl.: H01M 10/48, H02J 7/02, H02J 7/00, H01M 10/44, G01R 31/36, H01M 10/42

(54) **WIRELESS CHARGING MODULE AND WIRELESS CHARGING SYSTEM**
DRAHTLOSLADEMODUL UND DRAHTLOSLADESYSTEM
MODULE DE CHARGE SANS FIL ET SYSTÈME DE CHARGE SANS FIL

(30) Priority: 14.03.2013 JP 2013052261
(43) Date of publication of application: 17.02.2016
(73) Proprietor: Maxell Holdings, Ltd., Kyoto 618-8525 (JP)
(72) Inventor: HINO Yoshiharu, Ibaraki-shi, Osaka 567-8567 (JP); MIYAKE, Akira, Ibaraki-shi, Osaka 567-8567 (JP)
(74) Representative: Diehl & Partner GbR
(86) International application number: PCT/JP2013/081134
(87) International publication number: WO 2014/141537

(56) References cited:
- JP-A- H07 107 676
- JP-A- H11 283 677
- JP-A- 2008 125 268
- JP-A- 2012 055 045
- JP-U- H 043 371
- US-A1- 2009 001 927
- US-A1- 2011 187 329

## Description

### Technical Field

The present invention relates to a wireless charging module for charging a rechargeable battery by reception of power that is transmitted from a power transmission side wirelessly (contactlessly) through electromagnetic induction or electromagnetic resonance, and relates to an improvement for effectively detecting a remaining capacity (remaining charge) of a rechargeable battery with reduced power consumption. The present invention further relates to a wireless charging system using such a wireless charging module.

### Background Art

Recently, a power transmission system that feeds power wirelessly has been adopted increasingly for small electronic set devices such as a mobile phone. By adopting a wireless charging system based on wireless power transmission for charging rechargeable batteries built in set devices, complicated charging operations are improved greatly. Small set devices such as a hearing aid that are operated by coin type lithium-ion batteries often have to be waterproof considering the use environment. Therefore, in terms of the form, wireless charging of the batteries is essential.

The wireless charging system includes a power transmitter, and a power receiver having a charging function, which is incorporated in a set device. Power is transmitted through electromagnetic induction between a power transmitting coil of the power transmitter and a power receiving coil of the power receiver. In the power receiver, a rectification circuit converts, to DC power, AC power received by a resonant circuit having the power receiving coil. The power output from the rectification circuit is converted to a charging voltage, whereby a rechargeable battery such as a lithium-ion rechargeable battery is charged.

Meanwhile, consumer devices such as a notebook computer that use a rechargeable battery as a power supply are required to have a function of detecting the remaining capacity and informing a user of it. Generally, a battery control IC of a small consumer battery performs high-accuracy current integration, and subtracts a used charge amount from a full charge capacity to calculate the remaining capacity.

For calculation of the remaining capacity using current integration, Patent Document 1, for example, discloses a remaining capacity detection device that is configured to calculate a full charge capacity correctly. Specifically, since the full charge capacity decreases owing to deterioration of battery, it is important to correctly estimate a full charge capacity after deterioration of rechargeable battery for improving the calculation accuracy of the remaining capacity.

In the device disclosed in Patent Document 1, at the beginning of discharging of a battery pack, a first estimation method is performed in which a DC resistance is calculated from changes in battery voltage and current value flowing through the battery pack, and a full charge capacity of the battery pack is calculated based on a relationship between the DC resistance and the full charge capacity. During discharging of the battery pack, a second estimation method is performed in which the full charge capacity of the battery pack is estimated from a relationship between an open-circuit voltage that is expected from a battery voltage and a used charge amount that is obtained from information of a current flowing through the battery pack. By combining these methods, a full charge capacity considering deterioration of battery is calculated with high accuracy, which even makes it possible to improve the accuracy of the remaining capacity detection of low-use batteries.

### Prior Art Document

### Patent Document

Patent Document 1: JP 2012-32267 A

Patent Document US2011/187329 discloses two methods for state of charge SOC determination, namely a low precision method using "in" and "out" current integration and a high precision method using an open voltage determination to compare with a predetermined translation to SOC.

### Disclosure of Invention

### Problem to be Solved by the Invention

Since the coin type rechargeable batteries have a low capacity, they often are used for a backup purpose, and rarely used for operations of device systems conventionally. Exceptionally, small devices with low power consumption such as a hearing aid use coin type batteries for system operations. Further, since the coin type lithium-ion batteries have a higher output than the conventional coin batteries, they are expected to be used not only for operations of small devices but also for operations of device systems in the future application.

Conventionally, the coin type rechargeable batteries are not intended to have a remaining capacity detection function due to their low capacity, because power consumption for the remaining capacity measurement largely affects usable time of the batteries. To cope with this, it is desired to mount a remaining capacity detection function by using coin type lithium-ion batteries with relatively large capacity and to adopt a wireless charging system. This is because, in order to increase the user's convenience, it is necessary to inform the device system side, which uses and manages a battery, of the remaining capacity of the battery, or to give feedback to the power transmission side on the battery capacity at the time of charging.

Incidentally, in the remaining capacity management of the low-capacity coin type rechargeable batteries, it is necessary to consider a trade-off relation between accuracy and power consumption. That is, high-accuracy management increases power consumption, whereas power saving decreases accuracy. Especially in the case of low-capacity rechargeable batteries, power consumption in the battery pack results in a decrease in power supply capability with respect to device systems, which significantly decreases the operation time of the device systems.

General rechargeable batteries have a high capacity and the charging capacity is not largely affected even when a circuit for battery remaining capacity detection is driven. Therefore, the general rechargeable batteries frequently operate the capacity detection when high detection accuracy is required. However, in the case of the coin type rechargeable batteries, if they frequently perform the battery capacity detection in the same manner as in the case of the general rechargeable batteries as disclosed in Patent Document 1, the useable time of the batteries may decrease extremely due to large self-consumption.

To cope with this, it is an object of the present invention to provide a wireless charging module capable of effectively detecting the remaining capacity of a rechargeable battery in a power saving manner.

Further, it is another object of the present invention to provide a wireless charging system capable of effectively managing a charging operation using such a wireless charging module.

### Means for Solving Problem

A basic configuration of a wireless charging module of the present invention includes: a power receiver having a power receiving resonant circuit that is composed of a power receiving coil and a resonant capacitor; and a rechargeable battery to which output power of the power receiver is supplied. A rectification circuit converts, to DC power, AC power generated in the power receiving resonant circuit through electromagnetic induction or electromagnetic resonance between a power transmitting coil of a power transmitter and the power receiving coil, so as to charge the rechargeable battery.

In order to solve the above-described problem, the wireless charging module of the present invention further includes: a capacity detection circuit for detecting a remaining capacity of the rechargeable battery; and a power reception controller for controlling an operation of the capacity detection circuit. The power reception controller is capable of operating the capacity detection circuit with switching between a high-accuracy measurement mode and a low-accuracy measurement mode, the high-accuracy measurement mode detecting the remaining capacity with high accuracy, and the low-accuracy measurement mode detecting the remaining capacity with accuracy lower than that of the high-accuracy measurement mode. The capacity detection circuit is operated in the high-accuracy measurement mode in charging of the rechargeable battery and in the low-accuracy measurement mode in discharging of the rechargeable battery.

### Effect of the Invention

According to the wireless charging module configured as above, by switching the measurement mode between in charging and in discharging, it is possible to reduce power consumption of the rechargeable battery. Specifically, in charging, since power is supplied externally, the operation time of the rechargeable battery is not affected by high-accuracy measurement consuming a large amount of power. On the other hand, in discharging, the measurement mode is switched to the low-accuracy measurement mode in which self-power consumption of the rechargeable battery is low. Thus, high-accuracy remaining capacity management can be executed in a power saving manner as a whole without sacrificing the operation time.

### Brief Description of Drawings

[FIG. 1] FIG. 1 is a block diagram showing a wireless charging system that includes a wireless charging module in one embodiment of the present invention.
[FIG. 2] FIG. 2 is a block diagram showing a capacity detection circuit in the wireless charging module.

### Description of the Invention

On the basis of the above configuration, the wireless charging module of the present invention can be modified as below.

Specifically, the power receiver discriminates between in charging and in discharging on the basis of a reception voltage output from the rectification circuit.

Further, in the power receiver, a frequency of the remaining capacity detection in the low-accuracy measurement mode is lower than that in the high-accuracy measurement mode.

Further, the capacity detection circuit and the power reception controller are configured to be capable of executing a first calculation method and a second calculation method, the first calculation method calculating the remaining capacity using data of voltage and current measured during charging or discharging on the basis of data stored in advance for calculating the remaining capacity in accordance with a charging and discharging characteristic curve, and the second calculation method calculating the remaining capacity using an integrated capacity obtained by integrating current measured during charging or discharging. In the high-accuracy measurement mode, the first calculation method and the second calculation method are executed in combination to calculate the remaining capacity. In the low-accuracy measurement mode, the remaining capacity is calculated from either the first calculation method or the second calculation method.

Further, the power receiver averages a charging and discharging characteristic measured and recorded at each charging and discharging cycle or at a predetermined charging and discharging cycle by a predetermined frequency so as to compute a charging and discharging characteristic after deterioration including deterioration in battery characteristic, and computes the remaining capacity on the basis of the charging and discharging characteristic after deterioration using at least one parameter selected from an integrated capacity, a voltage characteristic, a load current characteristic, a charging and discharging time at each cycle, and the number of charging cycles.

Further, the power receiver stores an initial charging and discharging characteristic of the rechargeable battery measured in advance, and calculates a difference between the charging and discharging characteristic after deterioration and the initial charging and discharging characteristic to correct the remaining capacity at a using point of time.

Furthermore, when the remaining capacity detected is below a predetermined lower limit of the remaining capacity, the power receiver transmits a warning signal to a connected set device system that uses the rechargeable battery as a power supply.

A wireless charging system of the present invention can be configured as below. The wireless charging system includes: a power transmitter having a power transmitting resonant circuit that is composed of a power transmitting coil and a resonant capacitor; and the wireless charging module with the above configuration. The power receiver binarizes information of the remaining capacity of the rechargeable battery detected by the capacity detection circuit, and has a transmitter that sequentially forwards data to the power transmitter side contactlessly. The power transmitter displays the remaining capacity on the basis of the forwarded data or transmits the forwarded data to a host system to which the power transmitter is connected.

Hereinafter, an embodiment of the present invention will be described with reference to the drawings.

### <Embodiment>

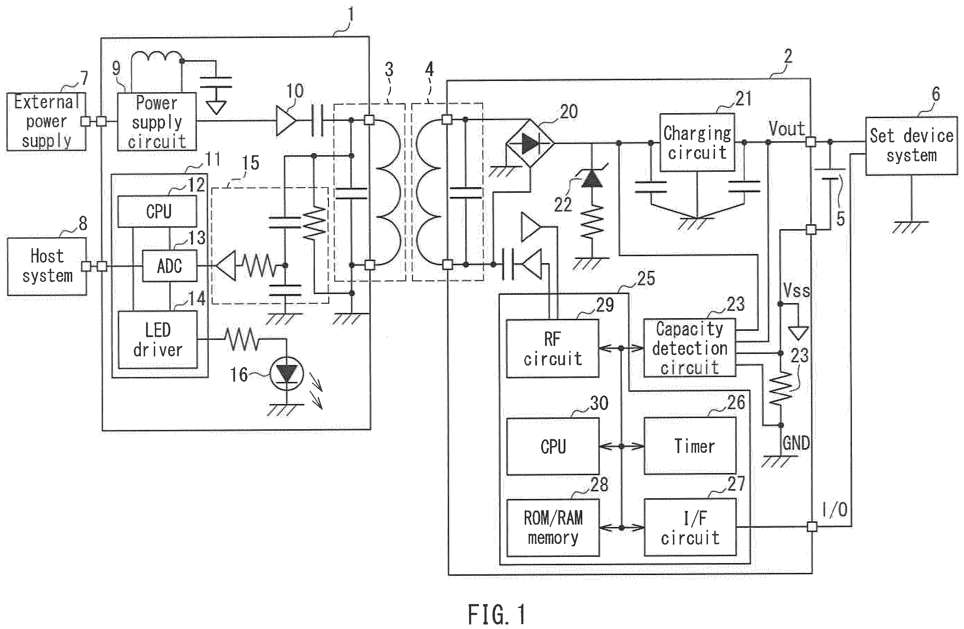

A wireless charging system in Embodiment 1 will be described with reference to the block diagram shown in FIG. 1. The charging system includes a power transmitter 1 and a power receiver 2 that constitute a wireless power transfer system. The power transmitter 1 is provided with a power transmitting resonant circuit 3 that is composed of a power transmitting coil and a resonant capacitor. The power receiver 2 is provided with a power receiving resonant circuit 4 that is composed of a power receiving coil and a resonant capacitor. The power transmitter 1 transmits power to the power receiver 2 through electromagnetic induction or electromagnetic resonance between these coils.

The power receiver 2 is incorporated into, e.g., an electronic set device such as a mobile phone and a hearing aid, and charges a rechargeable battery 5 such as a coin type lithium-ion battery built in the set device. The rechargeable battery 5 supplies power to a set device system 6. The power receiver 2 and the rechargeable battery 5 constitute a wireless charging module.

The power transmitter 1 is connected to an external power supply 7 and a host system 8 such as a computer. Power supplied from the external power supply 7 is adjusted by a power supply circuit 9, and supplied to the power transmitting resonant circuit 3 as high-frequency power via a coil driver 10. A CPU 12 of a power transmission controller 11 controls this operation. Communication between the power transmission controller 11 and the host system 8 manages operations of the power transmitter 1. In the case of only simple charging not requiring control by the host system 8, only the external power supply 7 is connected to the power transmitter 1, and the power receiver 2 is managed for system operation.

The power transmission controller 11 further is provided with anADC (AD converter) 13 and an LED driver 14. An output signal of a receiver 15 is supplied to the ADC 13. The LED driver 14 is connected to an LED 16. The receiver 15 is connected to the power transmitting resonant circuit 3, receives data communication by load modulation from the power receiver 2 via the power receiving resonant circuit 4, and inputs a reception signal to the ADC 13. The ADC 13 converts the reception signal to a digital signal, and supplies it to the CPU 12 and the LED driver 14. The CPU 12 reflects data obtained by this communication on control of the power supply circuit 9. The LED driver 14 causes the LED 16 to display information of the obtained data, e.g., a charging capacity (remaining capacity) of the rechargeable battery 5.

In the power receiver 2, a rectification circuit 20 converts AC power that is generated on both ends of the resonant capacitor of the power receiving resonant circuit 4, to DC power. A charging circuit 21 controls a reception voltage that is output from the rectification circuit 20 to a predetermined voltage, and supplies it to the rechargeable battery 5 for charging. A Zener diode 22 is inserted between a ground and a node that is present between an output terminal of the rectification circuit 20 and the charging circuit 21, thereby limiting a voltage to be applied to the charging circuit 21. A sense resistor 23 is connected between a negative electrode terminal of the rechargeable battery 5 and a ground so as to detect the remaining capacity of the rechargeable battery 5.

Both ends of the sense resistor 23 are connected to a capacity detection circuit 24 for detection of voltages at respective nodes. A positive electrode terminal of the rechargeable battery 5 also is connected to the capacity detection circuit 24 for detection of a voltage of the rechargeable battery 5. The capacity detection circuit 24 has a function of calculating the remaining capacity of the rechargeable battery 5 on the basis of these voltages. A reception voltage that is output from the rectification circuit 20 also is supplied to the capacity detection circuit 24 so as to switch operations. Specifically, if a reception voltage is detected, this means that the rechargeable battery 5 is in a charging mode and being charged by power transmitted from the power transmitter 1. Therefore, it is possible to discriminate between a charging mode and a discharging mode on the basis of the presence or absence of the reception voltage. As described later, operations are selected depending on the charging or discharging mode.

A power reception controller 25 is provided with a timer 26, an I/F circuit 27, a ROM/RAM memory 28, and a RF circuit 29. A CPU 30 controls operations of these elements, and controls operations of the capacity detection circuit 24 using these elements so as to detect the remaining capacity.

The timer 26 is used for time control, etc., of anADC in the capacity detection circuit 24. The I/F circuit 27 communicates with the set device system 6, and transmits data of the remaining capacity of the rechargeable battery 5 and controls the wireless charging system in accordance with the state of the set device. The ROM/RAM memory 28 stores data of charging and discharging characteristic curves for calculation of the remaining capacity from current and voltage values during charging or discharging. The CPU 30 calculates the remaining capacity on the basis of the voltages of the respective portions supplied to the capacity detection circuit 24 and the data of charging and discharging characteristic curves as described above. The RF circuit 29 performs data communication with the power transmitter 1 by load modulation through the power receiving resonant circuit 4 and the power transmitting resonant circuit 3, and transmits data of the remaining capacity detected by operations of the capacity detection circuit 24, etc., to the power transmitter 1.

This wireless charging system has characteristics in the power receiver 2 that constitutes the wireless charging module. Specifically, the power reception controller 25 operates the capacity detection circuit 24 with switching between a high-accuracy measurement mode and a low-accuracy measurement mode. The high-accuracy measurement mode detects the remaining capacity of the rechargeable battery 5 with high accuracy, and the low-accuracy measurement mode detects the remaining capacity with accuracy lower than that of the high-accuracy measurement mode. Thus, depending on a charging mode in which the rechargeable battery 5 is being charged by transmission power from the power transmitter 1 and a discharging mode in which the rechargeable battery 5 is not being charged, the capacity detection circuit 24 is operated in the high-accuracy measurement mode in charging and in the low-accuracy measurement mode in discharging.

In this manner, by switching the measurement mode between in charging and in discharging, it becomes possible to reduce power consumption of the rechargeable battery 5. Specifically, in charging, since power is supplied externally (wirelessly), the operation time of the rechargeable battery 5 is not affected by high-accuracy measurement, which consumes a large amount of power. On the other hand, in discharging, since the detection needs to be performed using the rechargeable battery 5 as a power supply, the measurement mode is switched to the low-accuracy measurement mode. In other words, the low-accuracy measurement reduces self-power consumption. Thereby, the remaining capacity detection as the entire operation can be performed in a power saving manner, and the high-accuracy remaining capacity management becomes possible without sacrificing the operation time.

In this embodiment, as an example, the switching between the high-accuracy measurement mode and the low-accuracy measurement mode is performed by discrimination between in charging or in discharging on the basis of a reception voltage, which is output from the rectification circuit 20 and supplied to the capacity detection circuit 24.

As exemplary operations for saving power in the low-accuracy measurement mode, it is possible to set the frequency of the capacity detection, i.e., the frequency of measurement (time interval), the timing of measurement (battery voltage fluctuation), etc., to be lower than those in the high-accuracy measurement mode. For example, in the high-accuracy measurement mode applied during charging, current integration is performed continuously to calculate the remaining capacity, whereas in the low-accuracy measurement mode applied during discharging, the remaining capacity may be calculated periodically from a relationship between voltage and current. Alternatively, power consumption may be reduced by changing the setting of measurement (e.g., accuracy of the ADC in the capacity detection circuit 24).

Alternatively, in order to set the high-accuracy measurement mode and the low-accuracy measurement mode, the capacity detection circuit 24 and the power reception controller 25 are configured to be capable of executing the following first calculation method and second calculation method. Specifically, the first calculation method is set to calculate the remaining capacity from current and voltage values during charging or discharging on the basis of charging and discharging characteristic curves. That is, the first calculation method is set to calculate the remaining capacity using data of voltage and current measured during charging or discharging on the basis of data on charging and discharging characteristic curves stored in the ROM/RAM memory 28 in advance. The second calculation method is set to calculate the remaining capacity by integrating currents measured during charging or discharging and using the obtained integrated capacity.

In the high-accuracy measurement mode, the first calculation method and the second calculation method are executed in combination to calculate the remaining capacity in combination of these methods. In the low-accuracy measurement mode, the remaining capacity is calculated from either the first calculation method or the second calculation method. Thus, in the low-accuracy measurement mode, executing either one of these methods can reduce power consumption of the rechargeable battery 5.

In the above configuration, in order to improve the accuracy of the remaining capacity detection, it is desirable to perform a correction with respect to a change in charging and discharging characteristics due to deterioration in battery characteristics. For example, the power reception controller 25 averages charging and discharging characteristics measured and recorded at each charging and discharging cycle or at a predetermined charging and discharging cycle by a predetermined frequency so as to compute charging and discharging characteristics after deterioration including deterioration in battery characteristics. Then, the power reception controller 25 computes the remaining capacity on the basis of the charging and discharging characteristics after deterioration using at least one parameter selected from the integrated capacity, voltage characteristics, load current characteristics, charging and discharging time at each cycle, and the number of charging cycles (corresponding to charging time).

Further, in the power reception controller 25, the ROM/RAM memory 28 stores initial charging and discharging characteristics of the rechargeable battery measured in advance. The power reception controller 25 calculates a difference between the initial charging and discharging characteristics stored in the ROM/RAM memory 28 and the charging and discharging characteristics after deterioration, thereby correcting the remaining capacity at the using point of time.

Further, the power reception controller 25 may be configured so that, by setting a lower limit of the remaining capacity for appropriate usage of the rechargeable battery 5, it transmits a warning signal to the set device system 6 when the detected remaining capacity is below the lower limit of the remaining capacity. Further, the power reception controller 25 may be configured so that, by measuring the charging capacity, it judges the end of the battery life when a deterioration in capacity reaches a predetermined value or when an integrated charging time reaches a predetermined value, and transmits a warning signal to the set device system 6 or to the power transmitter 1 and the host system 8.

Further, as a configuration of the wireless charging system, the power receiver 2 can be configured so that information of the remaining capacity of the rechargeable battery 5 that is detected by the capacity detection circuit 24, etc., is binarized, and the RF circuit 29 sequentially forwards the data to the power transmitter 1 side contactlessly. In this case, the power transmitter 1 can be configured so that the LED 16 displays the remaining capacity on the basis of the forwarded data. Alternatively, the forwarded data may be transmitted to the host system 8 to which the power transmitter 1 is connected. In the case of the wireless charging system, since the power transmitter 1 side cannot detect the remaining capacity directly, such a configuration is useful for controlling the charging operations of the power transmitter 1.

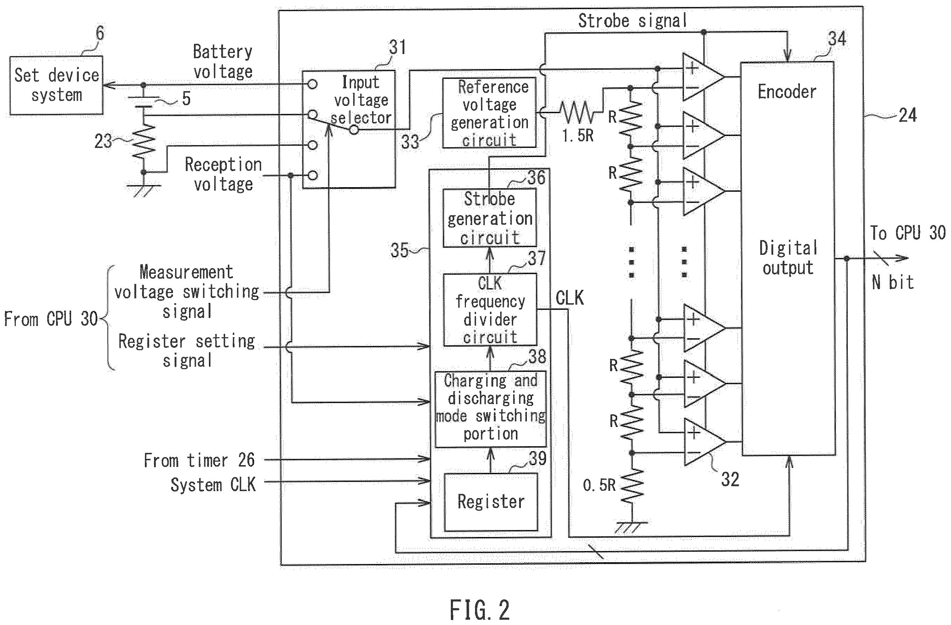

Next, an exemplary configuration of the capacity detection circuit 24 and its operations will be described with reference to the block diagram of FIG. 2. Voltages of the respective portions of the power receiver 2 are supplied to an input voltage selector 31 provided in the capacity detection circuit 24. The voltages of the respective portions are a battery voltage of the rechargeable battery 5, voltages at both ends of the sense resistor 23, and a reception voltage that is an output of the rectification circuit 20. The capacity detection circuit 24 receives a measurement voltage switching signal from the CPU 30, the input voltage selector 31 performs switching accordingly, and the voltage selected among the voltages of the respective portions is input to a comparator 32.

An ADC (converter) that is composed of the comparator 32, a reference voltage generation circuit 33, resistances (1.5 R, R, 0.5 R), and an encoder 34 converts the selected voltage from analog to digital, and outputs it to the CPU 30. Specifically, in accordance with the switching by the input voltage selector 31, a battery voltage of the rechargeable battery 5, voltages at both ends of the sense resistor 23, and a reception voltage are sequentially converted from analog to digital, and supplied from the encoder 34 to the CPU 30. The CPU 30 computes a battery capacity on the basis of these data and data of charging and discharging characteristic curves stored in the ROM/RAM memory 28.

A measurement controller 35 controls operations of the ADC (32, 33, 1.5 R, R, 0.5 R, 34). For the control operations, the measurement controller 35 receives a register setting signal from the CPU 30, and also receives a reception voltage, a signal from the timer 26, and a system CLK The measurement controller 35 includes a strobe generation circuit 36, a CLK frequency divider circuit 37, a charging and discharging mode switching portion 38, and a register 39. On the basis of a register setting signal from the CPU 30, the register 39 stores a basic setting of the ADC operations.

On the basis of the reception voltage that is an output of the rectification circuit 20, the charging and discharging mode switching portion 38 outputs a switching signal for setting of a system CLK frequency dividing ratio of the CLK frequency divider circuit 37. Specifically, the charging and discharging mode switching portion 38 discriminates between a charging mode and a discharging mode according to the presence or absence of a reception voltage, and outputs a switching signal according to the selection of the high-accuracy measurement mode or the low-accuracy measurement mode.

The system CLK frequency dividing ratio of the CLK frequency divider circuit 37 is determined in accordance with a switching signal from the charging and discharging mode switching portion 38 and an AD conversion value from the encoder 34. The system CLK frequency dividing ratio in the low-accuracy measurement mode is set to be larger than that in the high-accuracy measurement mode. A clock to be output is supplied to the strobe generation circuit 36 and the encoder 34. The strobe generation circuit 36 generates a strobe signal, which then is supplied to the ADC to control the operation timing of the ADC. Thus, in accordance with the charging and discharging mode, the strobe generation circuit 36 controls the frequency of AD conversion.

A signal from the timer 26 is used to manage the frequency of measurement (time interval) for the remaining capacity detection. As described above, when the high-accuracy measurement mode is set as a combination of the first calculation method and the second calculation method, and the low-accuracy measurement mode is set as either the first calculation method or the second calculation method, the frequency of measurement can be set as follows. Specifically, in the high-accuracy measurement mode, the frequency of measurement is, e.g., the current integration: one time/second; and the voltage measurement: eight times/second. In the low-accuracy measurement mode, the frequency of measurement is, e.g., the current integration: 0.1 times/second; or the voltage measurement: 0.1 times/second.

In the low-accuracy measurement mode, by reducing a resolution of the AD converter from, e.g., 10 bits to 8 bits or lowering the operation clock from 10 MHz to 5 MHz, power consumption of an AD conversion circuit can be reduced. The reduction in frequency of measurement as described above also can be employed together.

### Industrial Applicability

Since the wireless charging system of the present invention can execute the remaining capacity management with high accuracy while reducing power consumption of a rechargeable battery and keeping the operation time, it is useful for small electric devices such as a mobile phone and a hearing aid.

### Description of Reference Numerals

1 power transmitter
2 power receiver
3 power transmitting resonant circuit
4 power receiving resonant circuit
5 rechargeable battery
6 set device system
7 external power supply
8 host system
9 power supply circuit
10 coil driver
11 power transmission controller
12, 30 CPU
13 ADC
14 LED driver
15 receiver
16 LED
20 rectification circuit
21 charging circuit
22 Zener diode
23 sense resistor
24 capacity detection circuit
25 power reception controller
26 timer
27 I/F circuit
28 ROM/RAM memory
29 RF circuit
31 input voltage selector
32 comparator
33 reference voltage generation circuit
34 encoder
35 measurement controller
36 strobe generation circuit
37 CLK frequency divider circuit
38 charging and discharging mode switching portion
39 register

## Claims

1. A wireless charging module, comprising:
a power receiver (2) having a power receiving resonant circuit (4) that is composed of a power receiving coil and a resonant capacitor; and
a rechargeable battery (5) to which output power of the power receiver is supplied, wherein a rectification circuit (20) converts, to DC power, AC power generated in the power receiving resonant circuit through electromagnetic induction or electromagnetic resonance between a power transmitting coil (3) of a power transmitter (1)
and the power receiving coil, so as to charge the rechargeable battery, the wireless charging module further comprising:
a capacity detection circuit (23) for detecting a remaining capacity of the rechargeable battery; and
a power reception controller (30) for controlling an operation of the capacity detection circuit,
wherein the power reception controller is capable of operating the capacity detection circuit with switching between a high-accuracy measurement mode and a low-accuracy measurement mode, the high-accuracy measurement mode detecting the remaining capacity with high accuracy, and the low-accuracy measurement mode detecting the remaining capacity with accuracy lower than that of the high-accuracy measurement mode, and
the capacity detection circuit is operated in the high-accuracy measurement mode in charging of the rechargeable battery and in the low-accuracy measurement mode in discharging of the rechargeable battery.

2. The wireless charging module according to claim 1, wherein the power receiver discriminates between in charging and in discharging on the basis of a reception voltage output from the rectification circuit.

3. The wireless charging module according to claim 1 or 2, wherein in the power receiver, a frequency of the remaining capacity detection in the low-accuracy measurement mode is lower than that in the high-accuracy measurement mode.

4. The wireless charging module according to any one of claims 1 to 3,
wherein the capacity detection circuit and the power reception controller are configured to be capable of executing a first calculation method and a second calculation method, the first calculation method calculating the remaining capacity using data of voltage and current measured during charging or discharging on the basis of data stored in advance for calculating the remaining capacity in accordance with a charging and discharging characteristic curve, and the second calculation method calculating the remaining capacity using an integrated capacity obtained by integrating current measured during charging or discharging,
in the high-accuracy measurement mode, the first calculation method and the second calculation method are executed in combination to calculate the remaining capacity, and
in the low-accuracy measurement mode, the remaining capacity is calculated from either the first calculation method or the second calculation method.

5. The wireless charging module according to any one of claims 1 to 4, wherein the power receiver averages a charging and discharging characteristic measured and recorded at each charging and discharging cycle or at a predetermined charging and discharging cycle by a predetermined frequency so as to compute a charging and discharging characteristic after deterioration including deterioration in battery characteristic, and computes the remaining capacity on the basis of the charging and discharging characteristic after deterioration using at least one parameter selected from an integrated capacity, a voltage characteristic, a load current characteristic, a charging and discharging time at each cycle, and the number of charging cycles.

6. The wireless charging module according to claim 5, wherein the power receiver stores an initial charging and discharging characteristic of the rechargeable battery measured in advance, and calculates a difference between the charging and discharging characteristic after deterioration and the initial charging and discharging characteristic to correct the remaining capacity at a using point of time.

7. The wireless charging module according to any one of claims 1 to 6, wherein when the remaining capacity detected is below a predetermined lower limit of the remaining capacity, the power receiver transmits a warning signal to a connected set device system that uses the rechargeable battery as a power supply.

8. A wireless charging system, comprising:
a power transmitter having a power transmitting resonant circuit that is composed of a power transmitting coil and a resonant capacitor; and
the wireless charging module according to claim 1,
wherein the power receiver binarizes information of the remaining capacity of the rechargeable battery detected by the capacity detection circuit, and has a transmitter that sequentially forwards data to the power transmitter side contactlessly, and
the power transmitter displays the remaining capacity on the basis of the forwarded data or transmits the forwarded data to a host system to which the power transmitter is connected.

## Patentansprüche

1. Drahtloses Lademodul, mit:
einem Leistungsempfänger (2) mit einem Leistungsaufnahme-Schwingkreis aus einer Leistungsaufnahme-Spule und einem Resonanz-Kondensator; und
einer wiederaufladbaren Batterie (5), der die vom Leistungsempfänger abgegebene Leistung zugeführt wird,
wobei eine Gleichricht-Schaltung (20) den vom Leistungsaufnahme-Schwingkreis erzeugten Wechselstrom durch elektromagnetische Induktion oder elektromagnetische Resonanz zwischen einer Leistungsübertragungs-Spule (3) eines Leistungs-Überträgers (1) und der Leistungsaufnahme-Spule in Gleichstrom umwandelt, um die wiederaufladbare Batterie aufzuladen,
wobei das drahtlose Lademodul ferner aufweist:
eine Kapazitäts-Erfassungsschaltung (23) zum Erfassen einer verbleibenden Kapazität der wiederaufladbaren Batterie; und
einer Leistungsempfangs-Steuerung zum Steuern der Funktion der Kapazitäts-Erfassungsschaltung,
wobei die Leistungsempfangs-Steuerung (30) dazu ausgebildet ist, die Kapazitäts-Erfassungsschaltung derart zu betreiben, dass zwischen einem hoch-genauen Messmodus und einem nieder-genauen Messmodus umgeschaltet wird, wobei der hoch-genaue Messmodus die verbleibende Kapazität mit hoher Genauigkeit erfasst und der nieder-genaue Messmodus die verbleibende Kapazität mit niedrigerer Genauigkeit erfasst als der hoch-genaue Messmodus, und die Kapazitäts-Erfassungsschaltung beim Laden der wiederaufladbaren Batterie im hoch-genauen Messmodus betrieben wird, und beim Entladen der wiederaufladbaren Batterie im nieder-genauen Messmodus betrieben wird.

2. Drahtloses Lademodul gemäß Anspruch 1, wobei der Leistungsempfänger zwischen Laden und Entladen auf der Grundlage einer von der Gleichricht-Schaltung ausgegebenen Empfangsspannung unterscheidet.

3. Drahtloses Lademodul gemäß Anspruch 1 oder 2, wobei im Leistungsempfänger eine Frequenz der Erfassung der verbleibenden Kapazität im nieder-genauen Messmodus niedriger ist, als im hoch-genauen Messmodus.

4. Drahtloses Lademodul gemäß einem der Ansprüche 1 bis 3,
wobei die Kapazitäts-Erfassungsschaltung und die Leistungsempfangs-Steuerung dazu ausgebildet sind, eine erste Berechnungsmethode und eine zweite Berechnungsmethode auszuführen, wobei die erste Berechnungsmethode die verbleibende Kapazität unter Verwendung von Daten der Spannung und des Stroms berechnet, die beim Laden oder Entladen gemessen werden, auf der Grundlage von im Vorhinein gespeicherten Daten zum Berechnen der verbleibenden Kapazität in Übereinstimmung mit einer Lade-und Entlade-Kennlinie, und die zweite Berechnungsmethode die verbleibende Kapazität unter Verwendung einer integrierten Kapazität berechnet, die durch Integrieren der beim Laden und Entladen gemessenen Stroms gemessen wird, wobei im hoch-genauem Messmodus die erste Berechnungsmethode und die zweite Berechnungsmethode in Kombination ausgeführt werden, um die verbleibende Kapazität zu berechnen, und
im nieder-genauem Messmodus die verbleibende Kapazität entweder nach der ersten Berechnungsmethode oder nach der zweiten Berechnungsmethode berechnet wird.

5. Drahtloses Lademodul gemäß einem der Ansprüche 1 bis 4, wobei der Leistungsempfänger bei jedem Lade- und Entladezyklus oder in einem durch eine vorbestimmte Frequenz gegebenen vorbestimmten Lade- und Entladezyklus gemessene und aufgezeichnete Lade- und Entlade-Charakteristika mittelt, um Lade- und Entlade-Charakteristika nach Verschlechterung einschließlich einer Verschlechterung der Batterie-Charakteristika zu berechnen, und die verbleibende Kapazität auf der Grundlage der Lade- und Entlade-Charakteristika nach Verschlechterung unter Verwendung wenigstens eines Parameters zu berechnen, der ausgewählt ist aus integrierter Kapazität, Spannungs-Charakteristika, Verbraucher-Strom-Charakteristika, Lade- und Entladezeit bei jedem Zyklus und Anzahl der Ladezyklen.

6. Drahtloses Lademodul gemäß Anspruch 5, wobei der Leistungsempfänger initiale Lade- und Entlade-Charakteristika der wiederaufladbaren Batterie im Vorhinein speichert, und einen Unterschied zwischen den Lade- und Entlade-Charakteristika nach Verschlechterung und den initialen Lade- und Entlade-Charakteristika berechnet, um die verbleibende Kapazität zu einem Verwendungszeitpunkt zu korrigieren.

7. Drahtloses Lademodul gemäß einem der Ansprüche 1 bis 6, wobei, wenn die erfasste verbleibende Kapazität unter einer vorgegebenen unteren Grenze der verbleibenden Kapazität liegt, der Leistungsempfänger ein Warnsignal an ein Geräteverbund-System ausgibt, das die wiederaufladbare Batterie als Stromquelle verwendet.

8. Drahtloses Ladesystem, mit:
einem Leistungsüberträger mit einem Leistungsübertragungs-Schwingkreis aus einer Leistungsüberträger-Spule und einem Resonanz-Kondensator; und
dem drahtlosen Lademodul gemäß Anspruch 1,
wobei der Leistungsempfänger Information über die von der Kapazitäts-Erfassungsschaltung erfasste verbleibende Kapazität der wiederaufladbaren Batterie binarisiert, und einen Sender beinhaltet, der sequenziell Daten über die Leistungsüberträger-Seite kontaktlos weiterleitet, und
der Leistungsüberträger die verbleibende Kapazität auf der Grundlage der weitergeleiteten Daten anzeigt oder die weitergeleiteten Daten an ein Host-System weiteleitet, an das der Leistungsüberträger angeschlossen ist.

## Revendications

1. Module de charge sans fil, comprenant :
un récepteur d'énergie (2) ayant un circuit résonant de réception d'énergie (4) qui est composé d'une bobine de réception d'énergie et d'un condensateur résonant; et
une batterie rechargeable (5) à laquelle l'énergie de sortie du récepteur d'énergie est fournie,
dans lequel un circuit de redressement (20) convertit en énergie en courant continu de l'énergie en courant alternatif générée dans le circuit résonant de réception d'énergie par induction électromagnétique ou résonance électromagnétique entre une bobine de transmission d'énergie (3) d'un transmetteur d'énergie (1) et la bobine de réception d'énergie, de manière à charger la batterie rechargeable,
le module de charge sans fil comprenant en outre :
un circuit de détection de capacité (23) pour détecter une capacité restante de la batterie rechargeable ; et
une commande de réception d'énergie (30) pour commander une exploitation du circuit de détection de capacité,
dans lequel la commande de réception d'énergie est capable d'exploiter le circuit de détection de capacité avec une commutation entre un mode de mesure de haute précision et un mode de mesure de basse précision, le mode de mesure de haute précision détectant la capacité restante avec une précision élevée, et le mode de mesure de basse précision détectant la capacité restante avec une précision inférieure à celle du mode de mesure de haute précision, et
le circuit de détection de capacité est exploitée dans le mode de mesure de haute précision en chargeant la batterie rechargeable et dans le mode de mesure de basse précision en déchargeant la batterie rechargeable.

2. Module de charge sans fil selon la revendication 1, dans lequel le récepteur d'énergie discrimine entre une charge et une décharge sur la base d'une tension de réception sortie du circuit de redressement.

3. Module de charge sans fil selon la revendication 1 ou 2, dans lequel dans le récepteur d'énergie, une fréquence de la détection de capacité restante dans le mode de mesure de basse précision est inférieure à celle dans le mode de mesure de haute précision.

4. Module de charge sans fil selon l'une quelconque des revendications 1 à 3,
dans lequel le circuit de détection de capacité et la commande de réception d'énergie sont configurés pour être capable d'exécuter un premier procédé de calcul et un second procédé de calcul, le premier procédé de calcul calculant la capacité restante en utilisant des données de tension et d'intensité mesurées pendant la charge ou la décharge sur la base de données stockées à l'avance pour calculer la capacité restante en fonction d'une courbe caractéristique de charge et de décharge, et le second procédé de calcul calculant la capacité restante en utilisant une capacité intégrée obtenue en intégrant une intensité mesurée pendant la charge ou la décharge,
dans le mode de mesure de haute précision, le premier procédé de calcul et le second procédé de calcul sont exécutés en combinaison pour calculer la capacité restante, et
dans le mode de mesure de basse précision, la capacité restante est calculée à partir du premier procédé de calcul ou du second procédé de calcul.

5. Module de charge sans fil selon l'une quelconque des revendications 1 à 4, dans lequel le récepteur d'énergie fait la moyenne d'une caractéristique de charge et de décharge mesurée et enregistrée à chaque cycle de charge et de décharge ou à un cycle de charge et de décharge prédéterminé à une fréquence prédéterminée de manière à calculer une caractéristique de charge et de décharge après une détérioration incluant une détérioration de caractéristique de batterie, et calcule la capacité restante sur la base de la caractéristique de charge et de décharge après détérioration en utilisant au moins un paramètre choisi parmi une capacité intégrée, une caractéristique de tension, une caractéristique de courant de charge, un temps de charge et de décharge à chaque cycle, et le nombre de cycles de charge.

6. Module de charge sans fil selon la revendication 5, dans lequel le récepteur d'énergie stocke une caractéristique de charge et de décharge initiale de la batterie rechargeable mesurée à l'avance, et calcule une différence entre la caractéristique de charge et de décharge après détérioration et la caractéristique de charge et de décharge initiale pour corriger la capacité restante à un instant d'utilisation.

7. Module de charge sans fil selon l'une quelconque des revendications 1 à 6, dans lequel lorsque la capacité restante détectée est inférieure à une limite inférieure prédéterminée de la capacité restante, le récepteur d'énergie transmet un signal d'avertissement à un système de dispositif de réglage connecté qui utilise la batterie rechargeable comme une source d'énergie.

8. Système de charge sans, comprenant :
un émetteur d'énergie ayant un circuit résonant de transmission d'énergie qui est composé d'une bobine de transmission d'énergie et d'un condensateur résonant ; et
le module de charge sans fil selon la revendication 1,
dans lequel le récepteur d'énergie binarise des informations de la capacité restante de la batterie rechargeable détectée par le circuit de détection de capacité, et a un émetteur qui transfère séquentiellement des données du côté de l'émetteur d'énergie de manière sans contact, et
l'émetteur d'énergie affiche la capacité restante sur la base des données transférées ou transmet les données transférées à un système hôte auquel l'émetteur d'énergie est connecté.
